# EUROPÄISCHE PATENTSCHRIFT

(11) **EP 1 906 461 B1**
(45) Veröffentlichungstag und Bekanntmachung des Hinweises auf die Patenterteilung: **18.03.2020**
(21) Anmeldenummer: 07016389.4
(22) Anmeldetag: 21.08.2007
(51) Int. Cl.: H01L 33/44, H01S 5/028, H01L 33/00

(54) **Verfahren zur Herstellung eines optoelektronischen Bauelements und optoelektronisches Bauelement**
Method for manufacturing an optoelectronic component and optoelectronic component
Procédé destiné à la fabrication d'un composant optoélectronique et composant optoélectronique

(30) Priorität: 26.09.2006 DE 102006045439; 16.11.2006 DE 102006054069
(43) Veröffentlichungstag der Anmeldung: 02.04.2008
(73) Patentinhaber: OSRAM Opto Semiconductors GmbH, 93055 Regensburg (DE)
(72) Erfinder: Härle, Volker, Dr., 93164 Laaber (DE); Höß, Christine, 93049 Regensburg (DE); Lell, Alfred, 93142 Maxhütte-Haidhof (DE); Strauß, Uwe, Dr., 93077 Bad Abbach (DE)
(74) Vertreter: Epping - Hermann - Fischer

(56) Entgegenhaltungen:
- EP-A2- 0 898 345
- JP-A- H0 927 639
- JP-A- 2000 332 342
- US-A- 5 140 457
- US-A1- 2004 238 828
- Karl H Guenther ET AL: "Reactive Ion Plating-A Novel Deposition Technique for Improved Optical Coatings", Proc. Soc. Vac. Coaters 31, 1 January 1988 (1988-01-01), pages 185-192, XP055500090, Retrieved from the Internet: URL:http://www.willeyoptical.com/pdfs/88_1 86.pdf [retrieved on 2018-08-15]
- SCHNITZER I ET AL: "30% EXTERNAL QUANTUM EFFICIENCY FROM SURFACE TEXTURED, THIN-FILM LIGHT-EMITTING DIODES", APPLIED PHYSICS LETTERS, A I P PUBLISHING LLC, US, vol. 63, no. 16, 18 October 1993 (1993-10-18), pages 2174-2176, XP000404433, ISSN: 0003-6951, DOI: 10.1063/1.110575

## Beschreibung

Die vorliegende Erfindung betrifft ein Verfahren zur Herstellung eines optoelektronischen Bauelements nach dem Oberbegriff des Anspruchs 1 und ein optoelektronisches Bauelement nach dem Oberbegriff des Anspruchs 16.

Optoelektronische Halbleiterchips wie Leuchtdioden (LEDs), Laserdioden oder Photodioden, werden beispielsweise wegen ihrer Kompaktheit und kostengünstigen Herstellung in zunehmendem Maße zu Schlüsselkomponenten für Anwendungen etwa in der Beleuchtungstechnik, Projektion, Datenspeicherung oder Drucktechnik. Die Herstellung beispielsweise von alterungsstabilen Laserdioden oder LEDs kann dabei eine besondere technologische Herausforderung darstellen.
Gemäß der Druckschrift M. Okayasu, M. Fukuda, T. Takeshita, S. Uehara, K. Kurumada, "Facet oxidation of InGaAs/GaAs strained quantum-well lasers", J. Appl. Phys., Volume 69, 1991, pp. 8346-8351 führt lichtinduzierte Oxidation einer Laserfacette zum Beispiel bei kantenemittierenden GaAs-Lasern zu Absorptionsverlusten und damit zur thermischen Erwärmung, was eine thermische Zerstörung der Laserfacette ("cathastrophic optical damage") und damit einen Bauteilausfall zur Folge haben kann.

Weiterhin ist aus den Druckschriften V. Kümmler, A. Lell, V. Härle, U. T. Schwarz, T. Schödl, W. Wegscheider, "Gradual facet degradation of (Al,In)GaN quantum well lasers", Applied Physics Letters, Volume 84, Number 16, 2004, pp. 2989-2991 und T. Schödl, U. T. Schwarz, S. Miller, A. Leber, M. Furitsch, A. Lell, V. Härle, "Facet degradation of (Al,In)GaN heterostructure laser diodes", Phys. stat. sol. (a), Volume 201, Number 12, 2004, pp. 2635-2638 bekannt, dass bei AlInGaN-Lasern mit unpassivierten Laserfacetten bei Betrieb in Feuchtigkeit eine verstärkte Degradation der Bauteile beobachtet werden kann.
Die Druckschrift EP 0 898 345 A2 beschreibt eine Halbleiterlaserdiode, die eine Facettenbeschichtung in Form einer Passivierungsschicht und weiteren Schichten aufweist.

In der Druckschrift US 2004/0238828 A1 ist ein optisches integriertes Bauelement angegeben, das beispielsweise ein DBR- oder DFB-Laser sein kann.

Die Druckschrift JP 2000-332342 A betrifft eine Laserdiode, die reflektierende Beschichtungen aufweist, die beispielsweise mittels eines ionenunterstützten Verfahrens aufgebracht werden können.

Die Druckschrift JP 09-027639 A beschreibt ein Verfahren zur Herstellung einer LED, bei dem eine isolierende Schicht bis auf Bereiche, in denen Elektroden angeordnet sind, auf alle freiliegenden Oberflächen einer Halbleiterschichtenfolge aufgebracht wird.

Die Druckschrift US 5,140,457 A beschreibt eine Vielzahl von Materialien, die geeignet sind, um so genannte kalte Reflektoren ("cold mirrors") herzustellen.

Der Artikel von Karl H. Guenther et al. "Reactive Ion Plating - A Novel Deposition Technique for Improved Optical Coatings", Proc. Soc. Vac. Coaters 31, 185-192 (1988) befasst sich mit einer Studie zu reaktivem Ionenplattieren zur Herstellung von Beschichtungen auf Glas-Substraten.

Es ist etwa möglich, Laserdioden beispielsweise in hermetisch dichte Gehäuse unter Schutzgas einzubauen. Ein Öffnen des Gehäuses kann dabei jedoch zu einer massiven Bauteilalterung führen. Auch sind solche hermetisch dichten Gehäuse beispielsweise nachteilig beispielsweise hinsichtlich erhöhter Mehrkosten in Verbindung mit einem erhöhten Montageaufwand sowie hinsichtlich einer begrenzten Flexibilität für zahlreiche Anwendungen in Bezug auf die Bauformgröße und Integration anderer optischer Komponenten.

Zumindest eine Aufgabe von bestimmten Ausführungsformen der vorliegenden Erfindung ist es, ein Verfahren zur Herstellung eines optoelektronischen Bauelements anzugeben, das ein ionengestütztes Aufbringverfahren umfasst. Weiterhin ist es eine Aufgabe von bestimmten Ausführungsformen der vorliegenden Erfindung, ein optoelektronisches Bauelement anzugeben.

Diese Aufgaben werden durch ein Verfahren mit den Merkmalen des unabhängigen Patentanspruchs 1 sowie durch ein optoelektronisches Bauelement mit den Merkmalen des unabhängigen Patentanspruchs 17 gelöst. Vorteilhafte Ausführungsformen und Weiterbildungen des Verfahrens und des Bauelements sind in den abhängigen Ansprüchen gekennzeichnet und gehen weiterhin aus der nachfolgenden Beschreibung und den Zeichnungen hervor.

Ein Verfahren zur Herstellung eines optoelektronischen Bauelements gemäß zumindest einer Ausführungsform der Erfindung umfasst insbesondere die Schritte:
A) Bereitstellen einer Halbleiterschichtenfolge mit zumindest einem aktiven Bereich, wobei der aktive Bereich geeignet ist, im Betrieb elektromagnetische Strahlung auszusenden, und
B) Aufbringen von zumindest einer Schicht direkt auf einer ersten Oberfläche der Halbleiterschichtenfolge mittels eines ionenunterstützten Aufbringverfahrens.

Dabei kann der aktive Bereich der Halbleiterschichtenfolge im Betrieb elektromagnetische Strahlung mit einem Spektrum insbesondere im ultravioletten bis infraroten Wellenlängenbereich erzeugen. Insbesondere kann das Spektrum beispielsweise eine spektrale Komponente bei einer Wellenlänge oder in einem Wellenlängenbereich aufweisen. Weiterhin kann das Spektrum eine oder mehrere spektrale Komponenten mit verschiedenen Wellenlängen oder Wellenlängenbereichen umfassen.

Bei einer weiteren Ausführungsform ist die Halbleiterschichtenfolge als Epitaxieschichtenfolge oder als strahlungsemittierender Halbleiterchip mit einer Epitaxieschichtenfolge, also als epitaktisch gewachsene Halbleiterschichtenfolge ausgeführt. Dabei kann die Halbleiterschichtenfolge beispielsweise auf der Basis eines anorganischen Materials, etwa von InGaAlN, wie etwa GaN-Dünnfilm-Halbleiterchips, ausgeführt sein. Unter InGaAlNbasierte Halbleiterchips fallen insbesondere solche, bei denen die epitaktisch hergestellte Halbleiterschichtenfolge, die in der Regel eine Schichtenfolge aus unterschiedlichen Einzelschichten aufweist, mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x+y ≤ 1 aufweist. Halbleiterschichtenfolgen, die zumindest eine aktive Schicht auf Basis von InGaAlN aufweisen, können beispielsweise bevorzugt elektromagnetische Strahlung mit einer oder mehreren spektralen Komponenten in einem ultravioletten bis grünen Wellenlängenbereich emittieren.

Alternativ oder zusätzlich kann die Halbleiterschichtenfolge auch auf InGaAlP basieren, das heißt, dass die Halbleiterschichtenfolge unterschiedliche Einzelschichten aufweist, wovon mindestens eine Einzelschicht ein Material aus dem III-V-Verbindungshalbleitermaterialsystem InₓAl_{y}Ga_{1-x-y}P mit 0 ≤ x ≤ 1, 0 ≤ y ≤ 1 und x + y ≤ 1 aufweist. Halbleiterschichtenfolgen, die zumindest eine aktive Schicht auf Basis von InGaAlP aufweisen, können beispielsweise bevorzugt elektromagnetische Strahlung mit einer oder mehreren spektralen Komponenten in einem grünen bis roten Wellenlängenbereich emittieren.

Alternativ oder zusätzlich kann die Halbleiterschichtenfolge auch andere III-V-Verbindungshalbleitermaterialsysteme, beispielsweise ein AlGaAs-basiertes Material, oder II-VI-Verbindungshalbleitermaterialsysteme aufweisen. Insbesondere eine aktive Schicht, die ein AlGaAs-basiertes Material aufweist, kann geeignet sein, elektromagnetische Strahlung mit einer oder mehreren spektralen Komponenten in einem roten bis infraroten Wellenlängenbereich zu emittieren.

Bei einer weiteren Ausführungsform ist die Halbleiterschichtenfolge oder der strahlungsemittierende Halbleiterchip als Dünnfilm-Halbleiterchip ausgeführt sein.

Ein Dünnfilm-Halbleiterchip zeichnet sich insbesondere durch folgende charakteristische Merkmale aus:
- an einer zu einem Trägerelement hin gewandten ersten Hauptoberfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20pm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Halbleiterchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Die Halbleiterschichtenfolge kann neben dem aktiven Bereich weitere funktionale Schichten und funktionelle Bereiche umfassen, etwa p- oder n-dotierte Ladungsträgertransportschichten, also Elektronen- oder Löchertransportschichten, p- oder n-dotierte Confinement- oder Cladding-Schichten, ein Aufwachs- oder Trägersubstrat, Pufferschichten, Schutzschichten und/oder Elektroden sowie Kombinationen daraus. Solche Strukturen den aktiven Bereich oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

Bei einer Ausführungsform des Verfahrens weist die Halbleiterschichtenfolge zwei Hauptoberflächen auf, die beispielsweise durch die jeweils von der Halbleiterschichtenfolge abgewandten Oberflächen der zuoberst sowie der zuunterst angeordneten Schicht der Halbleiterschichtenfolge gebildet werden. Insbesondere können die Hauptoberflächen Grenzflächen der Halbleiterschichtenfolge in einer Richtung senkrecht zu einer Haupterstreckungsebene der Halbleiterschichten und damit in einer Aufwachsrichtung der Halbleiterschichtenfolge bilden. Weiterhin kann die Halbleiterschichtenfolge Seitenflächen aufweisen, die an die zwei Hauptoberflächen angrenzen können und die Halbleiterschichtenfolge in einer Richtung parallel zu einer Haupterstreckungsebene, also lateral, begrenzen können. Insbesondere kann die erste Oberfläche eine solche Seitenfläche umfassen oder sein. Dabei kann es insbesondere möglich sein, dass die erste Oberfläche benachbart zum aktiven Bereich ist. Alternativ oder zusätzlich kann die erste Oberfläche auch eine Hauptoberfläche umfassen oder sein.

Bei einer weiteren Ausführungsform des Verfahrens weist die Halbleiterschichtenfolge eine Strahlungsaustrittsfläche auf, über die die in der aktiven Schicht im Betrieb erzeugte elektromagnetische Strahlung abgestrahlt werden kann. Besonders bevorzugt umfasst die erste Oberfläche eine Strahlungsaustrittsfläche oder ist eine Strahlungsaustrittsfläche. Beispielsweise kann es sich bei der Halbleiterschichtenfolge um eine kantenemittierende Laserdiode oder um eine seitenemittierende LED handeln, so dass die Strahlungsaustrittsfläche eine Seitenfläche umfassen oder sein kann. Weiterhin kann die Strahlungsaustrittsfläche beispielsweise auch zwei Seitenflächen umfassen, die bevorzugt durch zwei sich gegenüberliegende Seitenflächen der Halbleiterschichtenfolge gebildet werden können. Darüber hinaus kann die Strahlungsaustrittsfläche beispielsweise auch eine Mehrzahl von Seitenflächen oder alle Seitenflächen umfassen. Alternativ kann es sich bei der Halbleiterschichtenfolge auch um eine vertikal emittierende Laserdiode ("VCSEL") oder eine über zumindest eine Hauptoberfläche emittierende LED handeln, so dass das bedeuten kann, dass die Strahlungsaustrittsfläche eine Hauptoberfläche umfassen kann oder eine Hauptoberfläche sein kann.

Bei einer weiteren Ausführungsform des Verfahrens umfasst die erste Oberfläche alle Seitenflächen der Halbleiterschichtenfolge, so dass in dem Verfahrensschritt B) die Schicht auf allen Seitenflächen der Halbleiterschichtenfolge aufgebracht wird. Alternativ oder zusätzlich kann die erste Oberfläche auch eine oder beide Hauptoberflächen umfassen. Das Aufbringen der Schicht auf alle Seitenflächen der Halbleiterschichtenfolge kann beispielsweise vorteilhaft sein, wenn die Halbleiterschichtenfolge eine LED oder eine Laserdiode ist oder umfasst. Dabei kann es möglich sein, dass durch die Schicht beispielsweise an Chip- oder Mesakanten, insbesondere im Bereich des aktiven Bereichs, Leckstrompfade, ESD-Ausfälle und/oder Alterungseffekte vermindert oder vermieden werden.

Bei einer weiteren bevorzugten Ausführungsform des Verfahrens umfasst das Verfahren den weiteren Verfahrensschritt C) Aufbringen zumindest einer Schicht auf eine zweiten Oberfläche mittels eines ionengestützten Aufbringverfahrens, wobei die zweite Oberfläche auf einer der ersten Oberfläche abgewandten Seite der Halbleiterschichtenfolge angeordnet ist.

Insbesondere kann das bedeuten, dass eine Schicht auf einer der ersten Oberfläche gegenüberliegenden zweiten Oberfläche der Halbleiterschichtenfolge aufgebracht wird. Beispielsweise kann die zweite Oberfläche eine Seitenfläche und/oder eine Strahlungsaustrittsfläche umfassen oder sein. Ferner kann die zweite Oberfläche zur aktiven Schicht benachbart sein.

Bei einer weiteren Ausführungsform des Verfahrens ist die Schicht, die im Verfahrensschritt B) aufgebracht wird, verschieden von der Schicht, die im Verfahrensschritt C) aufgebracht wird. Dabei kann es sein, dass die Verfahrensschritte B) und C) nacheinander ausgeführt werden. Alternativ können die Schichten, die jeweils in den Verfahrensschritte B) und C) aufgebracht werden, gleich sein, also beispielsweise gleiche Materialien umfassen und/oder gleiche Dicken aufweisen. Die Verfahrensschritte B) und C) können dabei auch gleichzeitig durchgeführt werden.

Bei einer besonders bevorzugten Ausführungsform des Verfahrens wird im Verfahrensschritt B) auf die erste Oberfläche eine Schicht aufgebracht, die ein Oxid aufweist oder ein Oxid ist, insbesondere ein Metalloxid und/oder ein Halbmetalloxid. Die Schicht kann dabei beispielsweise geeignet sein, zu verhindern, dass Feuchtigkeit und/oder oxidierende Substanzen wie etwa Sauerstoff in Kontakt mit der ersten Oberfläche kommen. Dadurch kann es möglich sein, dass durch die Schicht eine Oxidation und/oder Degradation der ersten Oberfläche vermindert oder verhindert werden kann. Alternativ oder zusätzlich kann die Schicht, die im Verfahrensschritt B) auf die erste Oberfläche aufgebracht wird, beispielsweise auch ein Nitrid aufweisen.

Weiterhin kann die Schicht, die im Verfahrensschritt B) auf die erste Oberfläche aufgebracht wird, und/oder die Schicht, die im Verfahrensschritt C) auf die zweite Oberfläche aufgebracht wird, optische Eigenschaften aufweisen wie etwa eine Transmission oder eine Reflektivität für die im Betrieb in der aktiven Schicht erzeugte elektromagnetische Strahlung. Dabei kann beispielsweise auf die erste Oberfläche eine Schicht aufgebracht werden, die eine Reflektivität und/oder Transmission aufweist, die von der Reflektivität und/oder Transmission einer Schicht, die auf die zweite Oberfläche aufgebracht werden kann, verschieden sein kann.

Bei einer weiteren Ausführungsform des Verfahrens wird eine Mehrzahl von Schichten im Verfahrensschritt B) auf die erste Oberfläche und/oder im Verfahrensschritt C) auf die zweite Oberfläche aufgebracht. Besonders bevorzugt kann es dabei sein, wenn dabei eine erste Schicht und eine zweite Schicht aufgebracht werden. Die erste Schicht und die zweite Schicht können dabei ein Schichtenpaar bilden. Es kann weiterhin vorteilhaft sein, wenn eine Mehrzahl von Schichtenpaaren auf die erste Oberfläche und/oder eine Mehrzahl von Schichtenpaaren auf die zweite Oberfläche aufgebracht wird.

Besonders bevorzugt kann ein Schichtpaar aufgebracht werden, bei dem die erste Schicht einen ersten Brechungsindex und die zweite Schicht einen zweiten Brechungsindex aufweist, wobei der zweite Brechungsindex verschieden vom ersten Brechungsindex ist. Insbesondere kann ein Schichtenpaar, das eine erste und eine zweite Schicht mit verschiedenen Brechungsindices und jeweils einer Dicke von etwa einem Viertel einer Wellenlänge aufweist, diese Wellenlänge zumindest teilweise reflektieren. Insbesondere kann die Reflektivität mit der Anzahl der Schichtenpaare steigen, so dass für eine erwünschte Reflektivität eine Mehrzahl von Schichtenpaaren, etwa zwei bis zehn Schichtenpaare, aufgebracht werden können.

Alternativ kann eine Schicht eine Dicke von etwa einer halben Wellenlänge oder einem ganzzahligen Vielfachen davon aufweisen. Eine solche Schicht kann insbesondere zumindest teilweise transparent für diese Wellenlänge sein. Dabei kann beispielsweise eine Schicht mit einer Dicke, die vorzugsweise etwa dem ein- bis dreifachen einer halben Wellenlänge entspricht, aufgebracht werden. Eine solche Schicht kann geeignet sein, als Passivierungsschicht die Halbleiterschichtenfolge vor Feuchtigkeit und/oder oxidierenden Substanzen wie etwa Sauerstoff zu schützen und dabei eine erwünschte Transmission zu gewährleisten.

Insbesondere kann "eine Dicke von etwa einem Viertel einer Wellenlänge" oder "eine Dicke von etwa einer halben Wellenlänge" dabei auch bedeuten, dass die Dicke einer Schicht derart ist, dass die optische Weglänge für elektromagnetische Strahlung durch die Schicht etwa einem Viertel der Wellenlänge oder etwa der halben Wellenlänge entspricht. Die optische Weglänge ist dabei das Produkt aus dem Brechungsindex der Schicht und der geometrischen Dicke.

Bei einer weiteren Ausführungsform des Verfahrens umfasst ein Metalloxid oder ein Halbmetalloxid Aluminium, Silizium, Titan, Zirkonium, Tantal, Niobium, oder Hafnium. Weiterhin kann auch ein Nitrid zumindest eines der genannten Metalle und Halbmetalle aufweisen, beispielsweise Siliziumnitrid. Besonders bevorzugt umfasst das Metalloxid oder das Halbmetalloxid zumindest eines der Materialien Niobiumpentoxid, Hafniumdioxid, Aluminiumoxid, Siliziumdioxid, Titandioxid, Tantalpentoxid und Zirkoniumdioxid. Insbesondere kann es vorteilhaft sein, wenn ein Schichtenpaar aufgebracht wird aus einer ersten Schicht, die Tantalpentoxid und/oder Zirkoniumdioxid umfasst oder ist, und einer zweiten Schicht, die Siliziumdioxid umfasst oder ist.

Das ionenunterstützte Aufbringverfahren ist reaktives Ionenplattieren ("reactive ion plating"). Alternativ oder zusätzlich kann das ionenunterstützte Aufbringverfahren auch Merkmale des ionenunterstützen Aufbringens ("ion assisted deposition"), des Ionenstrahl-unterstützten Aufbringens ("ion beam assisted deposition") und/oder des Ionenstrahlinduzierten Aufbringens ("ion beam induced deposition") aufweisen oder eines diese Aufbringverfahren sein.
Das ionenunterstützte Aufbringverfahren kann dabei zumindest eines der folgenden Merkmale aufweisen:
- Erzeugung einer Gasatmosphäre, die beispielsweise Argon und/oder Sauerstoff und/oder ein anderes oder zusätzliches reaktives Gas aufweisen kann. Zusätzlich kann auch beispielsweise ein Sauerstoffstrahl für die Bildung von Oxiden auf die erste und/oder zweite Oberfläche gerichtet sein.
- Überführen eines aufzubringen Materials, etwa eines Metalls, eines Halbmetalls, eines Oxids oder eines Nitrids, aus einem festen Zustand in einen gasförmigen Zustand. Insbesondere können auch mehrere aufzubringende Materialien in einem festen Mischzustand vorliegen. Dieses Überführen, das etwa Verdampfen sein kann, kann beispielsweise durch reaktives Elektronenstrahlverdampfen möglich sein, beispielsweise mittels eines Niederspannungsplasmabogens in der Gasatmosphäre.
- Ionisieren des aufzubringenden Materials und Beschleunigung des ionisierten aufzubringenden Materials in einem elektrischen Feld zu der Halbleiterschichtenfolge hin, wodurch eine Aufbringung des Materials auf der ersten/und oder zweiten Oberfläche ermöglicht werden kann. Alternativ oder zusätzlich kann auch ein ionisiertes Gas und/oder ein ionisierter Gasstrahl, das oder der beispielsweise Sauerstoff oder ein anderes Gas aufweist, geeignet sein, das aufzubringende Material zu der ersten und/oder zweiten Oberfläche hin zu beschleunigen. Durch die Verwendung eines ionisierten Sauerstoffgases oder Sauerstoffstrahls kann beispielsweise die Bildung eines Oxids vorteilhaft begünstigt werden.

Bei dem ionenunterstützten Aufbringverfahren kann die kinetische Energie des verdampften aufzubringenden Materials in vorteilhafter Weise im Vergleich zu anderen Aufdampfverfahren erhöht werden, was eine erhöhte mittlere freie Weglänge zur Folge haben kann. Dadurch kann es möglich sein, dass Schichten mit einer erhöhten Dichte im Vergleich zu anderen Aufdampfverfahren herstellbar sind. Der Ausdruck "andere Aufdampfverfahren" kann dabei chemische oder physikalische Aufdampfverfahren bezeichnen, die keine ionenunterstützten Aufbringverfahren sind. Besonders bevorzugt weist eine mit einem ionenunterstützen Aufbringverfahren herstellbare Schicht nur wenige oder keine Einschlüsse von Gasen oder Verunreinigungen auf, sowie eine geringe Rauhigkeit und einen im Vergleich zu einem anderen Aufdampfverfahren höheren Brechungsindex. Eine hohe Dichte kann auch eine Durchlässigkeit für Feuchtigkeit und/oder Sauerstoff auf vorteilhafte Weise vermindern oder verhindern. Eine geringe Rauhigkeit kann vorteilhaft sein, um Streuverluste der im aktiven Bereich im Betrieb erzeugten elektromagnetischen Strahlung zu minimieren oder zu vermeiden. Weiterhin kann durch ein ionenunterstütztes Aufbringverfahren die Haftung der Schicht an der ersten und/oder zweiten Oberfläche oder einer weiteren Schicht auch der ersten und/oder zweiten Oberfläche vorteilhaft erhöht werden, wodurch eine erhöhte Haltbarkeit der Schicht ermöglicht werden kann.
Insbesondere kann eine Maske in Teilbereichen der Halbleiterschichtenfolge verwendet werden, um ein Aufbringen des Materials in diesen Teilbereichen der Halbleiterschichtenfolge zu vermeiden.
Weiterhin umfasst die Erfindung ein optoelektronisches Bauelement, das durch zumindest ein Verfahren der oben genannten Ausführungsformen erhalten ist.
Ferner umfasst ein optoelektronisches Bauelement gemäß zumindest einer Ausführungsform der Erfindung
- eine Halbleiterschichtenfolge mit zumindest einem aktiven Bereich, wobei der aktive Bereich geeignet ist, im Betrieb elektromagnetische Strahlung auszusenden, und
- zumindest einer Schicht auf zumindest einer Oberfläche, wobei die Schicht mittels eines ionenunterstützten Aufbringverfahrens herstellbar ist und ein Metalloxid und/oder Halbmetalloxid aufweist.

Insbesondere kann das ionenunterstützte Aufbringverfahren gemäß einer der weiter oben ausgeführten Ausführungsformen durchführbar sein.

Bei einer bevorzugten Ausführungsform weist die Schicht oder zumindest ein Teilbereich der Schicht eine Rauhigkeit auf, die beispielsweise durch topographische Oberflächenstrukturen wie Vertiefungen oder Erhebungen gebildet werden können. Die Schicht kann dabei eine Rauhigkeit auf einer der Halbleiterschichtenfolge zugewandten Oberfläche und/oder einer der Halbleiterschichtenfolge abgewandten Oberfläche aufweisen. Insbesondere kann eine Differenz aus der höchsten und der niedrigsten topographischen Oberflächenstruktur, also die maximale Höhendifferenz der topographischen Oberflächenstrukturen, eine Peak-to-Peak-Rauhigkeit definieren. Die Peak-to-Peak-Rauhigkeit der Schicht oder des Teilbereichs der Schicht kann dabei weniger als etwa 4 nm, bevorzugt kleiner oder gleich etwa 2 nm und besonders bevorzugt kleiner oder gleich etwa 1 nm sein.

Bei einer weiteren bevorzugten Ausführungsform weist die Schicht einen Brechungsindex von größer oder gleich 2,25 auf. Insbesondere kann dabei die Schicht Tantalpentoxid oder Zirkoniumdioxid aufweisen. Der Brechungsindex kann dabei bevorzugt einen Brechungsindex für elektromagnetische Strahlung in einem Wellenlängenbereich von etwa 390 nm bis etwa 430 nm bedeuten.

Bei einer weiteren Ausführungsform umfasst die Oberfläche zumindest eine Seitenfläche der Halbleiterschichtenfolge. Dabei kann die Seitenfläche beispielsweise benachbart zur aktiven Schicht der Halbleiterschichtenfolge sein. Insbesondere kann die Oberfläche eine Lichtaustrittsfläche für die im aktiven Bereich erzeugte elektromagnetische Strahlung sein.

Weitere Vorteile und vorteilhafte Ausführungsformen und Weiterbildungen der Erfindung ergeben sich aus den im Folgenden in Verbindung mit den in den Figuren 1A bis 3B beschriebenen Ausführungsformen.

Es zeigen:
- Figuren 1A bis 1C: schematische Darstellungen von Querschnitten von optoelektronischen Bauelementen während verschiedener Stadien eines Ausführungsbeispiels des Verfahrens,
- Figuren 2A bis 2C: schematische Darstellungen von Querschnitten von optoelektronischen Bauelementen während verschiedener Stadien eines weiteren Ausführungsbeispiels des Verfahrens, und
- Figuren 3A und 3B: Transmissionsmikroskopie-Aufnahmen von Schichten herstellbar nach einem Verfahren gemäß einem Ausführungsbeispiel und gemäß dem Stand der Technik.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

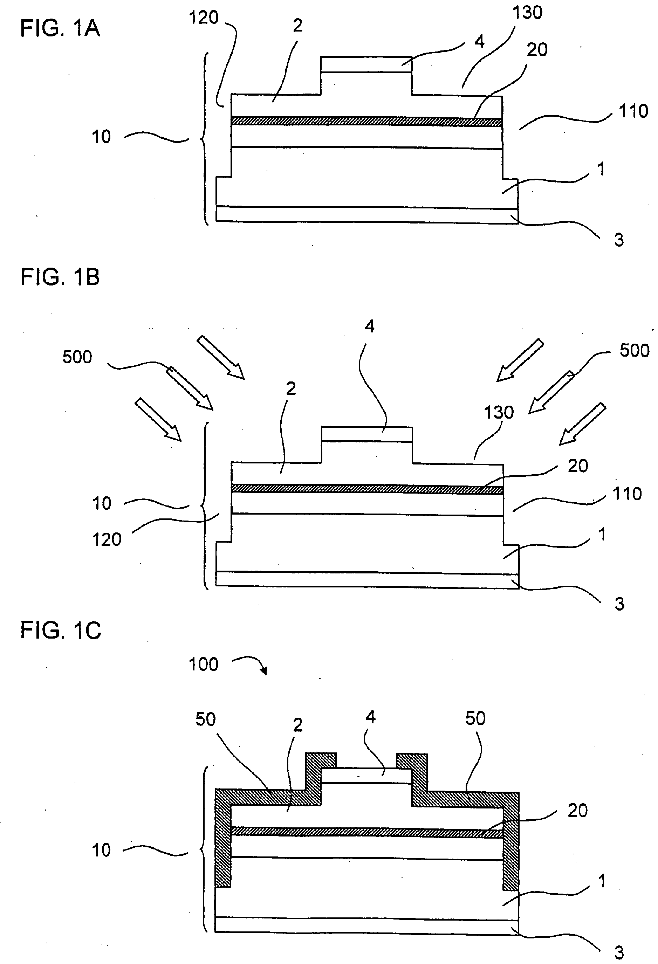

In dem Ausführungsbeispiel gemäß der Figuren 1A bis 1C sind verschiedene Stadien eines Verfahrens zur Herstellung eines optoelektronischen Bauelements 100 gezeigt.

Figur 1A zeigt dabei eine Halbleiterschichtenfolge 10, die in einem ersten Verfahrensschritt bereitgestellt wird. Die Halbleiterschichtenfolge 10 weist dabei eine auf einem Substrat 1 aufgewachsene Epitaxieschichtenfolge 2 mit einem aktiven Bereich 20 auf. Alternativ kann das Substrat 1 auch ein Trägersubstrat für eine Dünnfilm-Halbleiterschichtenfolge 10 sein. Die Halbleiterschichtenfolge 10 kann mittels zweier elektrischer Kontakte 3, 4 elektrisch kontaktiert und in Betrieb genommen werden. Der elektrische Kontakt 3 ist dabei bevorzugt als n-leitender Kontakt beziehungsweise als n-leitende Elektrode ausgebildet, während der elektrische Kontakt 4 als p-leitender Kontakt beziehungsweise als p-leitende Elektrode ausgebildet ist. Alternativ können auch der elektrische Kontakt 4 n-leitend und der elektrische Kontakt 3 p-leitend ausgebildet sein. Dementsprechend weist auch die Epitaxieschichtenfolge 2 n- und p-leitende Schichten und Bereiche auf. Der aktive Bereich 20 ist geeignet, im Betrieb elektromagnetische Strahlung zu emittieren. Die Materialien der Halbleiterschichtenfolge 2 und die Struktur des aktiven Bereichs 20 kann gemäß einer oder mehrerer Ausführungsformen im allgemeinen Teil der Beschreibung ausgeführt sein. Insbesondere weist die Halbleiterschichtenfolge 10 eine erste Oberfläche auf, die die Seitenflächen 110, 120 und zumindest teilweise die Hauptoberfläche 130 umfasst.

Die Halbleiterschichtenfolge 10 kann dabei beispielsweise eine Halbleiterschichtenfolge für eine LED sein, wobei die LED beispielsweise eine Strahlungsaustrittsfläche aufweist, die die Seitenflächen 110, 120 und/oder die Hauptoberfläche 130 umfasst. Alternativ kann die Halbleiterschichtenfolge 10 eine Halbleiterschichtenfolge für eine Laserdiode sein.

In Figur 1B ist gemäß einem weiteren Verfahrensschritt des Ausführungsbeispiels die Aufbringung 500 einer Schicht 50 (gezeigt in Figur 1C) auf die erste Oberfläche, also die Seitenflächen 110, 120 und die Hauptoberfläche 130, gezeigt. Damit die Schicht 50 nur auf der ersten Oberfläche aufgebracht wird, kann beispielsweise eine Maske verwendet werden (nicht gezeigt). Die Aufbringung der Schicht 50 erfolgt dabei mittels eines ionenunterstützten Aufbringverfahrens, nämlich mittels reaktiven Ionenplattierens. Dazu ist die Halbleiterschichtenfolge 10 vorzugsweise in einer Argonatmosphäre angeordnet, in der mittels eines Niederspannungsplasmabogens beispielsweise Tantal oder Tantalpentoxid verdampft und ionisiert wird und mittels eines elektrischen Felds und/oder eines zusätzlichen Sauerstoffstahls, der ebenfalls ionisiert sein kann, auf den Seitenflächen 110, 120 und der Hauptoberfläche 130 in Form einer Schicht, die Tantalpentoxid aufweist, aufgebracht wird. Alternativ kann auch beispielsweise eine Siliziumdioxidschicht oder eine Zirkoniumoxidschicht aufgebracht werden. Die Schicht 50 dient dabei insbesondere der Passivierung, das bedeutet, dass die Schicht 50 eine geringe Durchlässigkeit für Feuchtigkeit und oxidierende Substanzen wie etwa Sauerstoff aufweist.

Wie in Figur 1C gezeigt, weist das optoelektronische Bauelement 100 die Halbleiterschichtenfolge 10 mit der als Passivierungsschicht ausgebildeten Schicht 50 auf. Die Schicht 50 weist besonders bevorzugt eine Dicke von etwa dem 1,5-fachem der Wellenlänge der im aktiven Bereich 20 erzeugten elektromagnetischen Strahlung auf und zeichnet sich durch eine hohe Schichthomogenität ohne Einschlüsse oder Verunreinigungen aus. Da die Schicht 50 der Epitaxieschichtenfolge 2 und dem aktiven Bereich 20 benachbart ist, kann insbesondere der aktive Bereich 20 und die Epitaxieschichtenfolge 2 vor Feuchtigkeit und oxidierenden Substanzen wie etwa Sauerstoff geschützt werden. Weiterhin können beispielsweise nachteilige Effekte wie etwa Leckströme oder ESD-Ausfälle sowie Alterungseffekte vermindert oder verhindert werden.

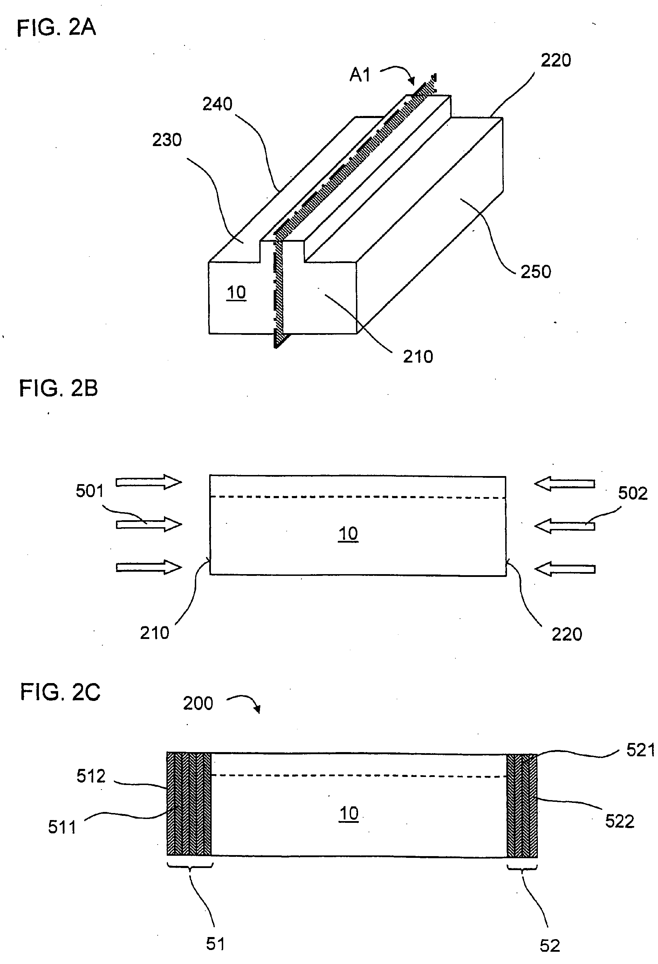

In Figur 2A ist eine schematische räumliche Darstellung eines Ausführungsbeispiels gezeigt, das eine in einem ersten Verfahrensschritt als kantenemittierende Laserdiode bereitgestellte Halbleiterschichtenfolge 10 für einen so genannten "Ridge-Waveguide Laser" zeigt. Die Halbleiterschichtenfolge 10 weist eine erste Oberfläche 210 und eine zweite Oberfläche 220 auf, die als Strahlungsaustrittsflächen ausgebildet sind. Dabei kann in einem weiteren Verfahrensschritt auf die Halbleiterschichtenfolge 10 nach deren Bereitstellung, insbesondere auf die Seitenflächen 240, 250 und/oder der Hauptoberfläche 230, eine Passivierungsschicht gemäß dem vorangegangenen Ausführungsbeispiel aufgebracht werden.

Figur 2B zeigt eine schematische Schnittdarstellung der Halbleiterschichtenfolge 10 entlang der die Figur 2A dargestellten Schnittebene A1. In weiteren Verfahrensschritten 501 und 502 wird auf die erste Oberfläche 210 und die zweite Oberfläche 220 mittels ionenunterstützten Aufbringverfahren jeweils ein Mehrzahl 51, 52 von Schichtenpaaren aufgebracht (wie in Figur 2C gezeigt). Die Mehrzahl 51 von Schichtenpaaren umfasst dabei Schichtenpaare jeweils mit einer ersten Schicht 511, die Tantalpentoxid oder Zinkoxid aufweist oder daraus ist, und einer zweiten Schicht 512, die Siliziumdioxid umfasst oder ist. Die Mehrzahl 52 von Schichtenpaaren auf der zweiten Oberfläche 220 umfasst Schichtenpaare jeweils mit einer ersten Schicht 521 und einer zweiten Schicht 522, die gleich einigen der Schichtenpaare der Mehrzahl 51 von Schichtenpaaren auf der ersten Oberfläche sind. Insbesondere können die Verfahrensschritte 501 und 502 dann teilweise gleichzeitig durchführbar sein.

Die Figur 2C zeigt das derartig hergestellte optoelektronische Bauelement 200 im gleichen Querschnitt wie Fig. 2B. Die ersten Schichten 511, 521 und die zweiten Schichten 512, 522 weisen eine Schichtdicke von etwa einem Viertel der Wellenlänge der in dem aktiven Bereich der Halbleiterschichtenfolge 10 erzeugten elektromagnetischen Strahlung auf. Dadurch können beide Mehrzahlen 51, 52 von Schichtenpaaren jeweils eine Reflektivität für die im aktiven Bereich erzeugte elektromagnetische Strahlung aufweisen. Die jeweilige Reflektivität kann entsprechend den Anforderungen an das optoelektronische Bauelement 200 gewählt sein. Beispielsweise kann die Mehrzahl 51 etwa 5 Schichtenpaare für eine Reflektivität von zumindest 90% aufweisen oder etwa 7 bis 10 Schichtenpaare für eine Reflektivität von zumindest 99%. Die Mehrzahl 51 von Schichtenpaaren kann auch eine Transmission aufweisen, so dass ein geringer Anteil der im aktiven Bereich der Halbleiterschichtenfolge 10 erzeugten elektromagnetischen Strahlung über die erste Oberfläche 210 und die Mehrzahl 51 von Schichtenfolgen emittiert werden kann. Dieser geringe Anteil kann beispielsweise als Monitorsignal zur Leistungs- oder Frequenzstabilisierung der erzeugten elektromagnetischen Strahlung genutzt werden.

Die Mehrzahl 52 von Schichtenpaaren auf der zweiten Oberfläche 220 weist bevorzugt weniger Schichtenpaare als die Mehrzahl 51 auf der ersten Oberfläche 210 auf, beispielsweise etwa 2 Schichtenpaare oder ein Schichtenpaar. Dadurch kann über die zweite Oberfläche 220 und die Mehrzahl 52 von Schichtenpaaren ein Teil der im aktiven Bereich der Halbleiterschichtenfolge 10 erzeugten elektromagnetischen Strahlung emittiert werden, während ein weiterer Teil in den aktiven Bereich zurückreflektiert werden kann um die Lasertätigkeit der Halbleiterschichtenfolge 10 zu unterstützen.

Alternativ kann auf die zweite Oberfläche 220 anstelle der Mehrzahl 52 von Schichtenpaaren auch nur eine einzelne Schicht als Passivierungsschicht mittels eines ionenunterstützten Aufbringverfahrens aufgebracht werden.

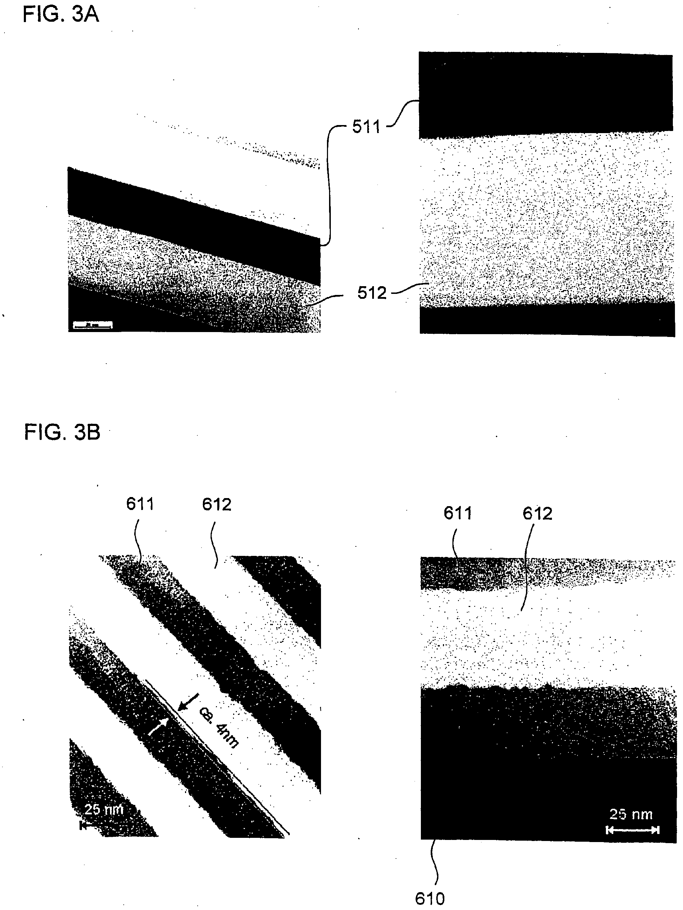

Die in dem geschilderten Ausführungsbeispielen aufgebrachten Schichtenpaare weisen dabei Eigenschaften auf wie in Verbindung mit der Figur 3A erläutert.

Die Figuren 3A und 3B zeigen je zwei Transmissionsmikroskopie-Aufnahmen von Teilausschnitten von Schichtenpaaren jeweils mit ersten Schichten 511, 611 und zweiten Schichten 512, 612 auf. Die Schichtenpaare gemäß der Figur 3A wurden dabei mittels Ionenplattierens hergestellt während die Schichtenpaare der Figur 3B mittels eines anderen, nicht-ionenunterstützten Bedampfungsverfahrens hergestellt wurden. Der Maßstab in den Aufnahmen der Figur 3A und den Aufnahmen der Figur 3B ist dabei in etwa gleich. Die ersten Schichten 511, 611 sind jeweils Tantalpentoxid-Schichten und die zweiten Schichten 512, 612 jeweils Siliziumdioxid-Schichten. Die Schichten wurden dabei jeweils auf ein GaN-Substrat 610 aufgebacht, das in einer der Aufnahmen der Figur 3B ebenfalls zu sehen ist.

Die durch Ionenplattieren hergestellten ersten und zweiten Schichten 511, 512 gemäß der Aufnahmen der Figur 3A weisen eine geringe Peak-to-Peak-Rauhigkeit von weniger als 1 nm an den Schichtgrenzen auf. Weiterhin weisen die ersten und zweiten Schichten 511, 512 keine erkennbaren Einschlüsse und jeweils eine sehr homogene Dichte, erkennbar durch die homogenen Färbungen in den Aufnahmen, auf. Ellipsometer-Messungen an den ersten Schichten 511 haben einen Brechungsindex von 2,25 bei einer Wellenlänge von etwa 390 nm bis etwa 430 nm ergeben.

Die durch ein nicht-ionenunterstütztes Bedampfungsverfahren hergestellten Schichtenpaare gemäß der Figur 3B weisen hingegen an den Schichtgrenzen der ersten und zweiten Schichten 611, 612 eine Peak-to-Peak-Rauhigkeit von etwa 4 nm auf. Weiterhin sind aus der unregelmäßigen Färbung der Schichten in den gezeigten Aufnahmen Dichteunterschiede in den jeweiligen Schichten durch Einschlüsse und Verunreinigungen erkennbar. Der Brechungsindex der ersten Schichten 611 betrug nur etwa 2,08 bei einer Wellenlänge von etwa 390 nm bis etwa 430 nm, was auf eine geringere Dichte als bei den Schichten 511 der Figur 3A schließen lässt.

Das Ionenplattieren zur Herstellung von Schichtenfolgen mit gemäß der Figur 3A gezeigten homogenen ersten und zweiten Schichten 511, 512 ermöglicht damit die Herstellung von Schichtenpaaren, die durch eine homogene und höhere Dichte bessere Barriereeigenschaften hinsichtlich Feuchtigkeit und Sauerstoff und bessere optische Eigenschaften aufweisen als Schichtenfolgen, die durch ein nicht-ionenunterstütztes Bedampfungsverfahren herstellbar sind.

Die Erfindung ist nicht durch die Beschreibung anhand der Ausführungsbeispiele auf diese beschränkt. Der Schutzbereich wird durch die Ansprüche definiert.

## Patentansprüche

1. Verfahren zur Herstellung eines optoelektronischen Bauelements, mit den Verfahrensschritten:
A) Bereitstellen einer Halbleiterschichtenfolge (10) mit zumindest einem aktiven Bereich (20), wobei der aktive Bereich (20) geeignet ist, im Betrieb elektromagnetische Strahlung auszusenden, und
B) Aufbringen (500, 501) von zumindest einer Schicht (50) direkt auf einer ersten Oberfläche (110, 210) der Halbleiterschichtenfolge (10) mittels eines ionenunterstützten Aufbringverfahrens, wobei die erste Oberfläche unmittelbar benachbart zum aktiven Bereich ist,
**dadurch gekennzeichnet, dass** das ionenunterstützte Aufbringverfahren reaktives Ionenplattieren ist.

2. Verfahren nach Anspruch 1, bei dem die erste Oberfläche eine Seitenfläche (110) der Halbleiterschichtenfolge ist.

3. Verfahren nach einem der vorherigen Ansprüche, bei dem die erste Oberfläche eine Strahlungsaustrittsfläche umfasst.

4. Verfahren nach einem der vorherigen Ansprüche, bei dem im Verfahrensschritt B) ein Metalloxid und/oder ein Halbmetalloxid aufgebracht wird.

5. Verfahren nach einem der vorherigen Ansprüche, bei dem im Verfahrensschritt B) ein Nitrid aufgebracht wird.

6. Verfahren nach einem der vorherigen Ansprüche, bei dem im Verfahrenschritt B) eine erste Schicht (511) und eine zweite Schicht (512) als Schichtpaar aufgebracht werden.

7. Verfahren nach dem vorherigen Anspruch, bei dem eine Mehrzahl (51) von Schichtpaaren aufgebracht wird.

8. Verfahren nach Anspruch 4, bei dem das Metalloxid oder das Halbmetalloxid zumindest ein Material aus einer Gruppe umfasst, die gebildet wird durch:
- Niobiumpentoxid,
- Hafniumoxid,
- Aluminiumoxid,
- Siliziumdioxid,
- Titandioxid,
- Tantalpentoxid und
- Zirkoniumdioxid.

9. Verfahren nach Anspruch 5, bei dem das Nitrid Siliziumnitrid aufweist.

10. Verfahren nach einem der Ansprüche 6 oder 7, bei dem als erste Schicht (511) Zirkoniumdioxid und als zweite Schicht (512) Siliziumdioxid aufgebracht wird.

11. Verfahren nach einem der Ansprüche 6 oder 7, bei dem als erste Schicht (511) Tantalpentoxid oder Tantalpentoxid und Zirkoniumdioxid und als zweite Schicht (512) Siliziumdioxid aufgebracht wird.

12. Verfahren nach einem der vorherigen Ansprüche, mit dem weiteren Verfahrensschritt:
C) Aufbringen (502) zumindest einer Schicht auf eine zweiten Oberfläche (220) mittels eine ionengestützen Aufbringverfahrens, wobei die zweite Oberfläche (220) auf einer der ersten Oberfläche (210) abgewandten Seite der Halbleiterschichtenfolge (10) angeordnet ist.

13. Verfahren nach dem vorherigen Anspruch, bei dem die zumindest eine Schicht, die im Verfahrensschritt B) aufgebracht wird, verschieden ist von der Schicht, die im Verfahrensschritt C) aufgebracht wird.

14. Verfahren nach Anspruch 12, wobei die Verfahrensschritte B) und C) gleichzeitig durchgeführt werden.

15. Verfahren nach einem der Ansprüche 2 bis 11, bei dem im Verfahrensschritt B) die Schicht auf alle Seitenflächen aufgebracht wird.

16. Optoelektronisches Bauelement, erhalten durch ein Verfahren nach Anspruch 1, wobei die im Verfahrensschritt B) auf die erste Oberfläche, die unmittelbar benachbart zum aktiven Bereich (20) ist, direkt aufgebrachte Schicht (50) ein Metalloxid und/oder Halbmetalloxid aufweist.

17. Optoelektronisches Bauelement nach Anspruch 16, wobei die zumindest eine Schicht (50) eine Peak-to-Peak-Rauhigkeit von weniger als etwa 4 nm aufweist.

18. Optoelektronisches Bauelement nach Anspruch 16 oder 17, wobei die Schicht (50) einen Brechungsindex von größer oder gleich 2,25 aufweist.

19. Optoelektronisches Bauelement nach einem der Ansprüche 16 bis 18, wobei die erste Oberfläche eine Seitenfläche (110, 120) der Halbleiterschichtenfolge umfasst.

20. Optoelektronisches Bauelement nach dem vorherigen Anspruch, wobei die Seitenfläche (110, 120) benachbart zu der aktiven Schicht (20) ist.

21. Optoelektronisches Bauelement nach einem der Ansprüche 16 bis 20, wobei die erste Oberfläche eine Lichtaustrittsfläche umfasst.

22. Optoelektronisches Bauelement nach einem der Ansprüche 16 bis 21, wobei die Halbleiterschichtenfolge als Dünnfilm-Halbleiterchip ausgebildet ist mit einem Trägerelement, einer reflektierenden Schicht an einer dem Trägerelement zugewandten ersten Hauptoberfläche einer strahlungserzeugenden Epitaxieschichtenfolge mit dem aktiven Bereich, wobei die Epitaxieschichtenfolge eine Dicke in einem Bereich von kleiner oder gleich 20 µm aufweist und zumindest eine Halbleiterschicht mit zumindest einer Fläche enthält, die eine Durchmischungsstruktur der von der Epitaxieschichtenfolge emittierten Strahlung aufweist.

23. Optoelektronisches Bauelement nach einem der Ansprüche 16 bis 21, wobei die Halbleiterschichtenfolge als kantenemittierende Laserdiode ausgebildet ist.

24. Optoelektronisches Bauelement nach einem der Ansprüche 16 bis 21, wobei die Halbleiterschichtenfolge als vertikal emittierende Laserdiode (VCSEL) ausgebildet ist.

## Claims

1. A method for producing an optoelectronic component, comprising the method steps of:
A) providing a semiconductor layer sequence (10) having at least one active region (20), wherein the active region (20) is suitable for emitting electromagnetic radiation during operation, and
B) applying (500, 501) at least one layer (50) directly on a first surface (110, 210) of the semiconductor layer sequence (10) by means of an ion assisted application method, wherein the first surface is directly adjacent to the active region,
**characterized in that** the ion assisted application method is reactive ion plating.

2. The method according to claim 1, in which the first surface is a side surface (110) of the semiconductor layer sequence.

3. The method according to one of the preceding claims, in which the first surface comprises a radiation exit area.

4. The method according to one of the preceding claims, in which a metal oxide and/or a semimetal oxide is applied in method step B).

5. The method according to one of the preceding claims, in which a nitride is applied in method step B).

6. The method according to one of the preceding claims, in which a first layer (511) and a second layer (512) are applied as a layer pair in method step B).

7. The method according to the preceding claim, in which a plurality (51) of layer pairs are applied.

8. The method according to claim 4, in which the metal oxide or the semimetal oxide comprises at least one material from a group consisting of:
- niobium pentoxide,
- hafnium oxide,
- aluminum oxide,
- silicon dioxide,
- titanium dioxide,
- tantalum pentoxide, and
- zirconium dioxide.

9. The method according to claim 5, in which the nitride comprises silicon nitride.

10. The method according to one of claims 6 and 7, in which zirconium dioxide is applied as first layer (511) and silicon dioxide is applied as second layer (512).

11. The method according to one of claims 6 and 7, in which tantalum pentoxide or tantalum pentoxide and zirconium dioxide is applied as first layer (511) and silicon dioxide is applied as second layer (512).

12. The method according to one of the preceding claims, comprising the further method step of:
C) applying (502) at least one layer to a second surface (220) by means of an ion assisted application method, the second surface (220) being arranged on a side of the semiconductor layer sequence (10) that is remote from the first surface (210).

13. The method according to the preceding claim, in which the at least one layer which is applied in method step B) is different from the layer which is applied in method step C) .

14. The method according to claim 12, wherein method steps B) and C) are carried out simultaneously.

15. The method according to one of claims 2 to 11, in which, in method step B), the layer is applied to all the side surfaces.

16. An optoelectronic component, obtained by a method according to claim 1, wherein the layer (50) being applied in method step B) directly to the first surface that is directly adjacent to the active region (20) comprises a metal oxide and/or semimetal oxide.

17. The optoelectronic component according to claim 16, wherein the at least one layer (50) has a peak-to-peak roughness of less than approximately 4 nm.

18. The optoelectronic component according to claim 16 or 17, wherein the layer (50) has a refractive index of greater than or equal to 2.25.

19. The optoelectronic component according to one of claims 16 to 18, wherein the first surface comprises a side surface (110, 120) of the semiconductor layer sequence.

20. The optoelectronic component according to the preceding claim, wherein the side surface (110, 120) is adjacent to the active layer (20).

21. The optoelectronic component according to one of claims 16 to 20, wherein the first surface comprises a light exit area.

22. The optoelectronic component according to one of claims 16 to 21, wherein the semiconductor layer sequence is embodied as thin-film semiconductor chip having a carrier element, a reflecting layer on a first main surface of a radiation-producing epitaxial layer sequence with the active region, the first main surface facing the carrier element, wherein the epitaxial layer sequence has a thickness in a range of less than or equal to 20 µm and comprises at least one semiconductor layer with at least one area that comprises a mixing structure of the radiation emitted by the epitaxial layer sequence.

23. The optoelectronic component according to one of claims 16 to 21, wherein the semiconductor layer sequence is embodied as edge-emitting laser diode.

24. The optoelectronic component according to one of claims 16 to 21, wherein the semiconductor layer sequence is embodied as vertically emitting laser diode (VCSEL).

## Revendications

1. Procédé en vue de la fabrication d'un composant optoélectronique, avec les étapes de procédé de :
A) mise à disposition d'une succession de couches à semiconducteurs (10) avec au moins une région active (20), sachant que la région active (20) convient pour émettre du rayonnement électromagnétique en fonctionnement, et
B) application (500, 501) d'au moins une couche (50) directement sur une première surface (110, 210) de la succession de couches à semiconducteurs (10) au moyen d'un procédé d'application assistée par faisceau d'ions, sachant que la première surface est directement voisine de la région active,
**caractérisé en ce que** le procédé d'application assistée par faisceau d'ions est le placage ionique réactif.

2. Procédé selon la revendication 1, lors duquel la première surface est une surface latérale (110) de la succession de couches à semiconducteurs.

3. Procédé selon une quelconque des revendications précédentes, lors duquel la première surface comporte une surface de sortie du rayonnement.

4. Procédé selon une quelconque des revendications précédentes, lors duquel est appliqué à l'étape de procédé B), un oxyde métallique et/ou un oxyde semi-métallique.

5. Procédé selon une quelconque des revendications précédentes, lors duquel, à l'étape de procédé B) est appliqué un nitrure.

6. Procédé selon une quelconque des revendications précédentes, lors duquel, à l'étape de procédé B) sont appliquées une première couche (511) et une seconde couche (512) comme paire de couches.

7. Procédé selon une quelconque des revendications précédentes, lors duquel est appliquée une pluralité (51) de paires de couches.

8. Procédé selon la revendication 4, lors duquel l'oxyde métallique ou l'oxyde semi-métallique comportent au moins un matériau qui est constitué par :
- du pentoxyde de niobium,
- de l'oxyde d'hafnium,
- de l'oxyde d'aluminium,
- du dioxyde de silicium,
- du dioxyde de titane,
- du pentoxyde de tantale et
- du dioxyde de zirconium.

9. Procédé selon la revendication 5, lors duquel le nitrure présente du nitrure de silicium.

10. Procédé selon une quelconque des revendications 6 ou 7, lors duquel est appliqué comme première couche (511) du dioxyde de zirconium et comme seconde couche (512) du dioxyde de silicium.

11. Procédé selon une quelconque des revendications 6 ou 7, pour lequel est appliqué comme première couche (511) du pentoxyde de tantale ou du pentoxyde de tantale et du dioxyde de zirconium et comme seconde couche (512) du dioxyde de silicium.

12. Procédé selon une quelconque des revendications précédentes, avec l'étape de procédé supplémentaire :
C) d'application (502) d'au moins une couche sur une seconde surface (220) au moyen d'un procédé d'application assistée par faisceau d'ions, sachant que la seconde surface (220) est disposée sur un côté détourné de la première surface (210) de la succession de couches à semiconducteurs (10).

13. Procédé selon la revendication précédente, lors duquel au moins l'une des couches qui est appliquée à l'étape de procédé B) est différente de la couche qui est appliquée à l'étape de procédé C).

14. Procédé selon la revendication 12, sachant que les étapes de procédé B) et C) sont réalisées simultanément.

15. Procédé selon une quelconque des revendications 2 à 11, lors duquel est appliquée à l'étape de procédé B) la couche sur toutes les surfaces latérales.

16. Composant optoélectronique, obtenu par un procédé selon la revendication 1, sachant que la couche directement appliquée (50) à l'étape de procédé B), qui est directement voisine de la région active (20), présente un oxyde métallique et/ou un oxyde semi-métallique.

17. Composant optoélectronique selon la revendication 16, sachant qu'au moins l'une des couches (50) présente une rugosité de crête à crête inférieure à environ 4 nm.

18. Composant optoélectronique selon les revendications 16 ou 17, sachant que la couche (50) présente un indice de réfraction supérieur ou égal à 2,25.

19. Composant optoélectronique selon une quelconque des revendications 16 à 18, sachant que la première surface comporte une surface latérale (110, 120) de la succession de couches à semiconducteurs.

20. Composant optoélectronique selon la revendication précédente, sachant que la surface latérale (110, 120) est voisine de la couche active (20).

21. Composant optoélectronique selon une quelconque des revendications 16 à 20, sachant que la première surface comporte une surface de sortie de lumière.

22. Composant optoélectronique selon une quelconque des revendications 16 à 21, sachant que la succession de couches à semiconducteurs est constituée comme puce électronique à film fin avec un élément porteur, une couche réfléchissante sur une première surface principale tournée vers l'élément porteur d'une succession de couches épitaxiales générant du rayonnement avec la région active, sachant que la succession de couches épitaxiales présente une épaisseur dans une région inférieure ou égale à 20 µm et contient au moins une couche à semiconducteurs avec au moins une surface, qui présente une structure de mélange du rayonnement émis par la succession de couches épitaxiales.

23. Composant optoélectronique selon une quelconque des revendications 16 à 21, sachant que la succession de couches à semiconducteurs est constituée comme diode laser à émission par le bord.

24. Composant optoélectronique selon une quelconque des revendications 16 à 21, sachant que la succession de couches à semiconducteurs est constituée comme diode laser à émission verticale (VCSEL).
